Europäisches Patentamt

European Patent Office

Office européen des brevets

(19)

(11) **EP 1 345 296 A1**

(12) **EUROPEAN PATENT APPLICATION**

(43) Date of publication:
**17.09.2003 Bulletin 2003/38**

(51) Int Cl.[7]: **H01S 5/0687**, H01S 5/0683

(21) Application number: **02251896.3**

(22) Date of filing: **16.03.2002**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | • **Franz, Michela**<br>**138 10028 Trofarello (TO) (IT)**<br>• **Grimaldi, Andrea**<br>**10137 Torino (IT)**<br>• **Miranda Sologuren, Eduardo Augusto**<br>**10100 Torino (IT)** |
| (71) Applicant: **Agilent Technologies, Inc. (a Delaware corporation)**<br>**Palo Alto, CA 94303 (US)** | (74) Representative: **Coker, David Graeme et al**<br>**Agilent Technologies UK Ltd,**<br>**Legal Dept,**<br>**Eskdale Road,**<br>**Winnersh Triangle**<br>**Wokingham, Berks RG41 5DZ (GB)** |
| (72) Inventors:<br>• **Lanco, Roberto**<br>**10040 Almese (IT)** | |

(54) **System for controlling power, wavelength and extinction ratio in optical sources, and computer program product therefor**

(57)    A system for controlling the operating parameters of an optical source (1), such as a laser diode in a transmitter module for optical communications, includes:

- a set of sensors (2, 3, 8) providing sensing signals indicative of the operating parameters to be controlled, and
- a set of control elements (5 to 7) adapted to affect the operating parameters of the optical source in dependence of the sensing signals.

The control elements include a digital controller such as a micro-controller (7) arranged to act both as a control system to maintain said operating parameters within respective pre-defined ranges and as a host interface to monitor the sensing signals and configure the system.

Fig - 1

EP 1 345 296 A1

## Description

Commercial WDM (Wavelength Division Multiplex) systems, especially of the "dense" type (DWDM) provide high transmission capacity operating with channel spacings of 50-100 GHz.

In order to ensure the wavelength stability required for the optical source, real time control of the wavelength emitted is an essential feature of the system. Wavelength control is currently implemented together with automatic power and extinction ratio (ER) control and such a combined system must be compact in size in order to be co-packaged with the other components such as the optical radiation source (typically a laser diode) included in WDM/DWDM transmitter modules while avoiding coupling, space and power dissipation problems.

The modules in question generally include a laser diode as the optical source emitting signal light together with a so-called "wavelength locker" arrangement - including a wavelength selective optical component and photodiodes to detect any wavelength and power variations in the laser source, a laser driver to bias the laser diode and a Peltier element for controlling the temperature of the laser diode together with its drive circuit.

A key factor to be taken into account in producing such control systems is flexibility, that is the possibility of adapting the same system to controlling devices with different characteristics (working point, bias current and temperature, requirements in terms of stability, frequency and power, driver response).

A number of different techniques have been proposed in the art in order to effect wavelength and power control of optical sources.

These include both analog arrangements, as disclosed e.g. in US-A-5 825 792, as well as micro-controller based systems for controlling a laser driver in a transceiver (see e.g. US-A-5 019 769). Fairly sophisticated wavelength control apparatus is also known e.g. from US-A-5 438 579 intended to counter temperature variations as the main source of undesired wavelength variations.

In order to realise a truly satisfactory wavelength, power and ER control system adapted to be associated to an optical source in a compact arrangement a number of basic requirements must be met, the most significant being:

- the control system must be flexible and cheap, and
- all components must be suitable to be mounted on board while admitting only pre-operational initialisation using external apparatus.

The object of the present invention is thus to provide an improved control system meeting the requirements outlined in the foregoing.

According to the present invention, such an object is achieved by means of a system having the features called for in the claims which follow. The invention also relates to the corresponding computer program product, that is a computer program product directly loadable into the internal memory of a digital controller and comprising software code portions which cause a digital controller to perform the function of the controller of the system of the invention when that product is run on the controller.

Essentially, the preferred embodiment of the invention consists of a wavelength, power and extinction ratio (ER) control system using a wavelength selective optical element and photodiodes to detect wavelength and power variations in combination with a digital controller such as a micro-controller to implement the control function by acting on the laser diode bias and modulation currents and temperature.

Preferably, the temperature of the laser diode and the external temperature are also monitored to maintain the laser source within the specified temperature range while compensating any temperature dependent fluctuation.

Using a digital controller such as a micro-controller enables pre-operational initialisation of the laser parameters, system auto-calibration as well as information concerning the status of the device (including alarms or warnings) being provided to the management function of the module.

The invention will now be described, by way of example only, with reference to the enclosed drawings, wherein:

- figure 1 is a block diagram showing the general layout of a system according to the invention,
- figure 2 is a state diagram of a finite state machine (FSM) implemented in a system according to the invention, and
- figures 3 to 6 are flow diagrams illustrating the processing functions adapted to be implemented in a system according to the invention.

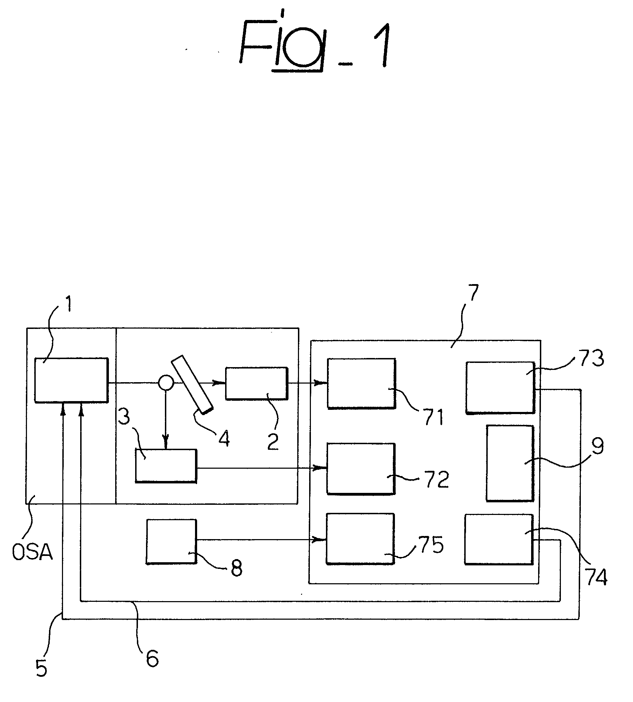

The arrangement shown in figure 1 essentially includes an optical source such as a laser diode 1 associated with first and second photosensitive elements 2 and 3 usually comprised of photodetectors such as photodiodes to form a so-called Optical Sub-Assembly (OSA).

First photodiode 2 has associated therewith a wavelength-selective element 4. Element 4 may be comprised of an optical filter centered at a wavelength corresponding to the nominal emission wavelength of laser source 1.

The arrangement in question, currently referred to as a "wavelength locker", provides for photodiode 3, used as reference, to sample an unfiltered portion of the laser beam. Another portion of the laser beam is passed through optical filter 4 and caused to impinge onto photodiode 2.

The response (i.e. the photocurrent) of photodiode 2 is thus a function of the possible displacement/misalignment of the actual wavelength of the beam generated by laser source 1 with respect to its nominal wavelength. Conversely, the response of photodiode 3 is indicative of the power emitted by laser source 1.

The arrangement in question is conventional in the art and does not require to be described in greater detail herein.

This also applies to the provision of elements or means permitting the wavelength and power of the radiation emitted by source 1 to be selectively controlled.

These currently include a thermoelectric cooler (TEC) such as a Peltier element (not shown) associated to laser source 1 and controlled via a line 5, thus permitting the laser temperature to be controlled and temperature-induced wavelength variations compensated.

Similarly, reference 6 designates a line adapted to convey a control signal of the laser source currents to enable selective control of the power emitted by source 1.

In the exemplary embodiment of the invention shown herein, the required control action of optical source 1 via the signals on lines 5 and 6 is effected as a function of the output signals of photodiodes 2 and 3 by means of a digital controller such as e.g. a micro-controller generally designated 7.

Being essentially a digital device, micro-controller 7 includes one or more analog-to-digital converters 71, 72 to convert into the digital format the output signals of photodiodes 2 and 3 as well as one or more digital-to-analog converters 73, 74 to convert the digital output signal of micro-controller 7 into analog signals adapted to be conveyed on lines 5 and 6.

The embodiment of the invention shown herein also includes a temperature sensor 8 sensitive to the external "ambience" temperature with respect to laser source 1.

A further analog-to-digital-converter 75 is thus included in micro-controller 7 to convert the output signal of temperature sensor 8 to the digital format.

Stated otherwise, in the arrangement shown, elements designated 2, 3, and 8 comprise a set of sensors providing sensing signals indicative the operating parameters of the optical source to be controlled, while elements designated 5 to 7 comprise a set of control elements adapted to affect the operating parameters of optical source 1 in dependence of the sensing signals.

Also, laser source 1, photodiodes 2 and 3 as well as wavelength selective element 4 comprise what is generally referred to as the Optical Sub-Assembly (OSA) or Transmitter Optical Sub-Assembly (TOSA).

The assembly comprised of micro-controller 7 with the associated analog-to-digital and digital-to-analog converters, and the "effectors" driven thereby, namely the laser current driver and the thermoelectrical cooler (TEC) driver, form what is usually referred to as the Electrical Sub-Assembly or ESA.

The arrangement of the invention provides for micro-controller 7 implementing two basic procedures, namely pre-operational calibration and in-line control algorithm.

During initial calibration, device dependent parameters are stored in a micro-controller memory, designated 9 in figure 1. Such device dependent parameters typically include operation current and temperature, setting points for the wavelength and power control and the correlation parameters between modulation signal and bias currents to compensate ageing effects.

The pre-operational calibration procedure is preferably performed in two steps.

In the first instance, the Optical Sub-Assembly (OSA) is evaluated in order to reject those samples which fail to meet the required performance specifications while at the same time measuring the absolute values of the respective parameters (OSA testing and calibration).

Specifically, the characteristics of the wavelength locker arrangement are evaluated together with the parameters used to compensate ageing phenomena of the modulation current.

Subsequently, after assembling the optical (OSA) and electrical (ESA) sub-assemblies, another calibration step is carried out to write in the micro-controller memory 9 data related to the working points and the control setting points.

This permits the module (OSA+ESA) to be started up in a "soft" manner, while taking into account the effect of the analog-to-digital conversion and permitting accurate wavelength, power and ER tuning. Further details concerning the soft start-up procedure can be gathered from a co-pending application filed concurrently with this application.

After the module has been safely started and brought to regular operation, the in-line algorithm implements four different control functions for the temperature, power, wavelength and extinction ratio of the radiation emitted by optical source 1, these control functions being related to one another.

The power control function uses the output of photo-detector 3 as an optical power monitor to act on the laser bias current (line 6).

The wavelength control function monitors wavelength variations of source 1 by using the output signal of photodiode 2. This is in fact a wavelength-selective signal due to the presence of element 4, that is usually comprised of an optical filter. The output signal from photodetector 3 is also used to normalise the wavelength sensitive signal in order to render it independent of power fluctuations. Wavelength stabilisation takes place primarily by controlling the junction temperature of laser diode 1 by means of a thermoelectric cooler (TEC) such as a Peltier element controlled via line 5.

The extinction ratio (ER) control function is based on feed forward control relying on the relationship between bias and modulation currents that yield a constant ER. Correlation data are calculated for each device during the TOSA (Transmitter Optical Sub-Assembly) testing and/or module programming procedures, by setting different laser temperatures.

This is based of the assumption that ageing effects (leading to an increase in laser threshold and to a decrease in the slope efficiency) can be estimated by increasing the laser temperature.

Still more in detail, micro-controller 7 executes two main tasks, acting both as control system and as host interface.

As the control system, micro-controller 7 implements all the control functions required in order to maintain the optical power, laser wavelength and the optical extinction ratio within pre-defined ranges, including an ageing tracking function.

As the host interface, micro-controller 7 implements the interface functions required to perform signal monitoring and to configure the module.

These functions are implemented on the basis of software code portions stored in an internal memory (typically a flash memory) of microcontroller 7. Consequently, the invention also covers the respective computer program product comprising these software code portions.

Operation of the control system provides for the interaction of four independent control functions coordinated by a finite state machine (FSM) implemented within micro-controller 7.

Each control function can be enabled or disabled by such a machine, that can also modify the functions in order to achieve specific operational conditions. Both the finite state machine and the control functions use several configuration parameters. These parameters are stored within the micro-controller internal memory 9 (usually an EEPROM) by initialising them to proper values during an external tuning procedure. Such "laser programming" procedure is usually performed during the last phase of manufacturing in the factory.

Specifically, the four control functions considered in the foregoing are: TEC temperature control, laser power control, laser wavelength control and extinction ratio control.

TEC (ThermoElectric Cooler) temperature control is implemented as a digital P-I (proportional-integral) controller designed to maintain the TEC temperature constant by using the TOSA (Transmitter Optical Sub-Assembly) thermistor as the temperature sensor.

The laser power control algorithm is again implemented as a digital P-I controller designed to maintain the optical power emitted by laser source 1 constant by using "power" photodiode 3 as the power sensor.

The laser wavelength control function is again implemented as digital P-I controller designed to maintain the wavelength of the radiation generated by laser source 1 constant by using the signals (photocurrents) generated by "power" photodiode 3 and "wavelength selective" photodiode 2 as wavelength sensors. This is done in order to dispense with any possible dependence of wavelength measurement on power and, to that effect, the controller implements a dual target algorithm. The two targets are a standard target (LI) and an offset ($D_{OFF}$) needed to compensate the optical power variations. These two targets are calculated during the laser programming step.

This is done by reading the digital values of the power monitor current, that is the photocurrent generated by photodiode 3 ($Imp_x$), and the filtered wavelength monitor current, that is the photocurrent generated by photodiode 2 ($Imf_x$) for two different temperatures (x=1; x=2).

Solving the following equations

$$L= (Imf_1.K+D_{OFF})/Imp_1$$

$$L=(Imf_2.K/D_{OFF})/Imp_2$$

where K is a constant usually set equal to 1024 gives the values for both the target L and $D_{OFF}$.

The extinction ratio control function is implemented as a digital feed forward procedure. The extinction ratio is the ratio between the optical power of a "1" and the optical power of a "0" emitted by laser source 1 and the control procedure is intended to maintain that ratio constant.

The function provides for calculating the proper value for the modulation current as a linear function of the bias current. The respective algorithm requires two parameters (the linear function coefficients). These two parameters are calculated in the TOSA initial calibration within the procedure that estimates the module ageing parameters. This procedure provides for both the bias current and the modulation current to be measured in order to obtain the same extinction ratio at the same output power at three different temperatures. This value is then verified to be correct also for the complete module (ESA+TOSA) by causing the laser programming function to set both bias and modulation currents in order that these have the same extinction ratio.

Consequently, by determining these currents for different temperatures (e.g. +5°C/-5°C from target temperature, assuming that ageing could be simulated by different temperatures), it is possible to obtain the coefficient which maintains the extinction ratio constant.

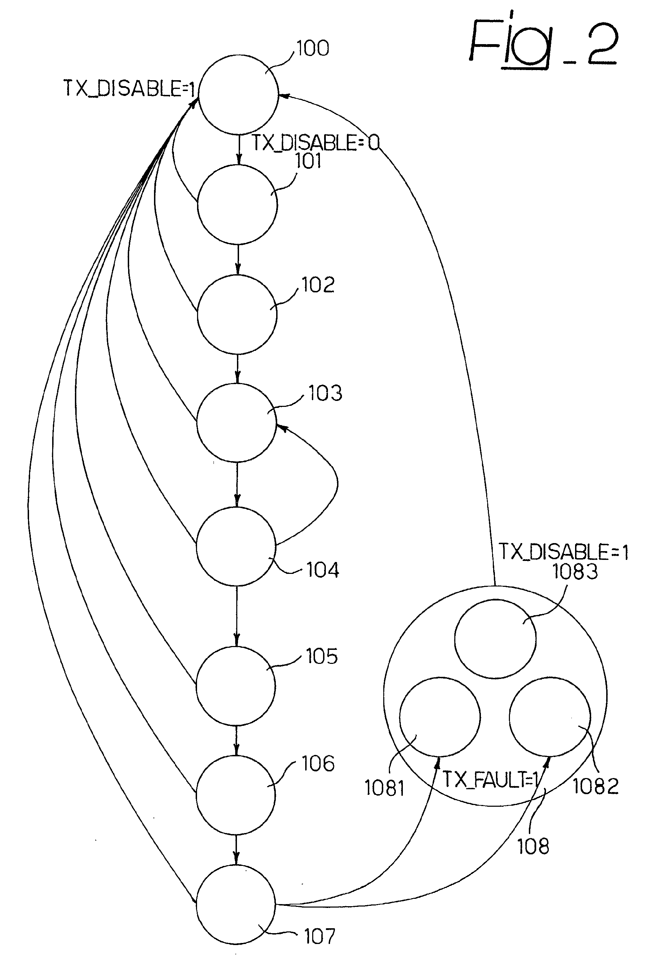

In figure 2 the state diagram of the finite state machine (FSM) that co-ordinates both the control function and the hardware peripherals (TEC driver, Laser driver, etc.) is shown by indicating the respective states by reference numerals 100 to 107.

Specifically, the finite state machine implemented by micro-controller 7 co-ordinates the control functions and the hardware peripherals (TEC driver, laser driver, and so on) to perform the start-up procedure in order to reach the module operation point after power-up.

As indicated, the details of a preferred form of such a start-up procedure form the subject matter of a co-pending application which is filed concurrently with this application

At each discrete state the finite state machine performs the following functions:

- enable/disable any control algorithm,
- enable/disable alarm verification; an alarm is fired if some signals are outside a predetermined interval (valid operating range),
- laser turn ON/OFF,
- turning ON/OFF the external signal (TX_FAULT) used to indicate either an operative error or some alarm,
- turning ON/OFF internal peripherals (TEC driver, laser driver, etc.).

Under particular conditions, the finite state machine can also set certain values of the bias modulation currents.

In the state diagram of figure 2, reference numeral 100 corresponds to the "zero" state where all controllers are turned off.

Setting of signal TX_DISABLE to level "0" leads the finite state machine to state 1, indicated by reference 101, where the temperature control is switched on. If temperature is found to be stable, the machine evolves to state 2, designated 102, to switch on laser diode 1.

After calculating - as explained in the foregoing - the initial power target, the machine evolves to state 3, designated 103 to switch on the power control function.

If power is found to be stable, the machine evolves to state 4, designated 104 to increase the power target. Evolution of the machine from state 4 is conditioned on power and temperature being stable and to the final power target having been reached.

If power is stable and temperature is stable and the final power target has not been reached yet, evolution is back to state 3, designated 103.

If, conversely, power and temperatures are stable and the final power target has been reached, evolution is towards state 5, designated 105, where laser wavelength control is switched on.

If wavelength is found to be stable, the machine evolves to state 6, designated 106, to switch on the extinction ratio control.

After waiting a pre-defined time, evolution is to the operative state, designated 107, where signal TX_FAULT is set to "0".

As shown in figure 2, if signal TX_DISABLE is set to "1" while the machine is any of the states 101 to 107, the machine is returned to "zero" state 100.

From 107 (that corresponds to the operative state of the module) the machine may evolve to further state 108. State 108 corresponds to a faulty condition having been identified and signal TX_FAULT being set to "1".

This event may prompted e.g. from either power or wavelength of the radiation emitted by laser source 1 being found to lie outside pre-defined limits, in which case the machine evolves towards a sub-state designated 1081 (laser power error) or a sub-state designated 1082 (laser wavelength error), respectively.

State 1080 may also include one or more additional sub-states, generally designated 1083, that may correspond to other absolute errors being detected in the module.

Evolution of the machine from state 108 back to state 100 corresponds to signal TX_DISABLE being set to "1" again.

The host interface implemented by micro-controller 7 is based on an 2-wire serial bus which allows the module to exchange messages with a host board following a pre-defined communication protocol.

Preferably, such protocol is comprised of a set of commands sent by the host to the module and a set of valid answers provided by the module to the host. Typically, the host is regarded as the bus master and all the modules connected to it are considered as slaves units. Stated otherwise, if the host does not issue any command, the module must not send any messages. Each message sent or received is validated with a checksum.

The communication protocol defines two classes of valid commands.

A first class is comprised of "factory only" commands, intended to permit the module to be configured by means of a factory host equipment. Configuration of the module typically involves supplying the module with control algorithm and parameters that are calculated as a result of the factory tuning procedure (so-called laser programming). Such "factory only" commands are disabled at the end of the laser programming phase in order to prevent the user from inadvertently modifying the module internal settings.

A second class of commands is comprised of general purpose commands, intended to permit a host board (either at the factory level or under user control) to read some module measurements. These are e.g. the current values of the module sensors to be used in monitoring module operation.

In the presently preferred embodiment of the invention such general purpose commands permit the following information to be read:

- TEC temperature,
- TEC current,
- board temperature (sensor 8 in figure 1),
- intensities of currents generated by photodiodes 2, 3,

- laser bias and modulation currents,
- start-up and alarm status and TX_FAULT signal value,
- identification information (serial number, part number, etc.).

Other general purpose commands may be included to allow the host board (factory/customer) to implement certain desired configurations, such as:

- laser wavelength fine adjustment (within a limited range),
- storing the actual operating point within the module memory 9 in order to force the module to reach that operating point during any future power-up.

During normal operation of the module, laser source 1 is currently subject to ageing effects leading to changes in its operating characteristics. During normal operation the control functions described in the foregoing maintain the laser operating point (optical power, wavelength and extinction ratio) constant by automatically adjusting the TEC temperature and the laser currents.

In a preferred embodiment of the invention, an ageing tracking procedure is implemented which consists in storing on a periodical basis (e.g. daily) at least one operating parameter such as the average values of TEC temperature and laser currents.

If the module is turned off and turned on again, the (new) start-up sequence is in a position to use those updated values in the place of factory-defined values to reach the actual ageing-compensated operating point.

As regards specifically the software implemented by micro-controller 7, the module program, designated as a whole 200 in figure 3, essentially provides for a configuration section 202 and a periodic section 204 to be performed according to the arrangement shown in the figure, where reference number 206 designates the step of waiting a given time interval (e.g. 10 ms).

Stated otherwise, when the module program is started, configuration section 202 is executed first. After completion thereof and a first "waiting" interval, periodic section 204 is performed cyclically with subsequent intermissions represented by step 206.

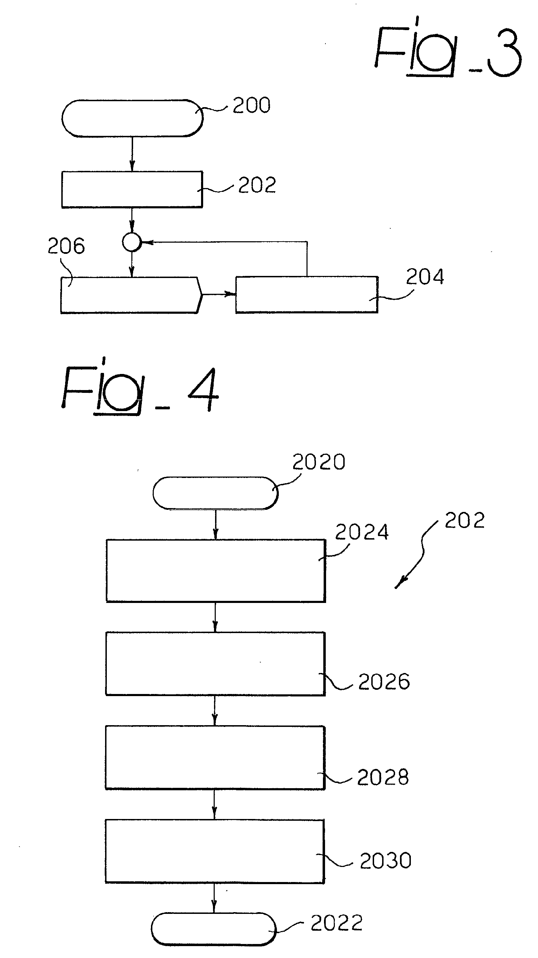

As better shown in the flow diagram of figure 4 configuration section 202 provides for the following steps to be implemented between a "start" step 2020 and a final step 2022 marking the end of configuration section:

- a micro-controller bootstrap step 2024 providing for power up and interrupts initialisation,
- a hardware initialisation step 2026 providing for I/O configuration and initialisation of peripherals,
- a initialisation step 2028 of the 2-wire serial bus providing for driver configuration and buffer initialisation, and
- a control algorithm/function initialisation step 2030 providing for initialisation of general variables and variables depending on the working point.

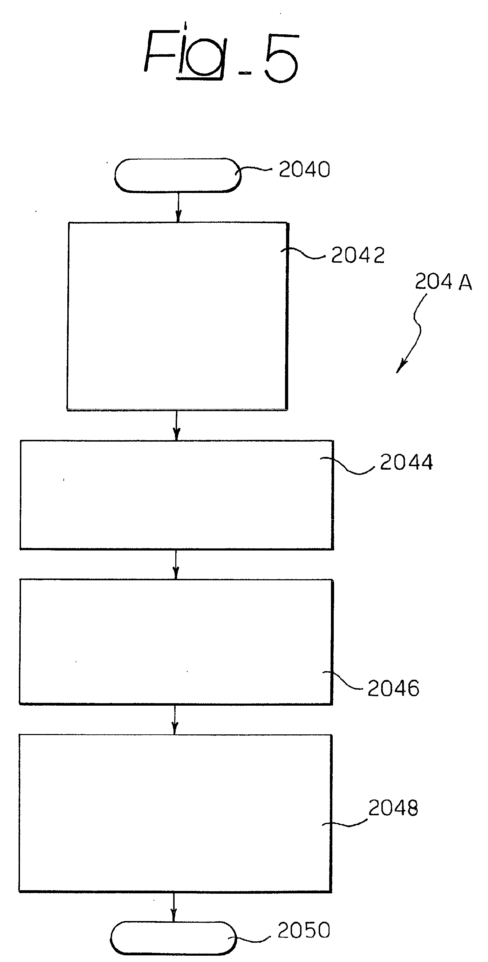

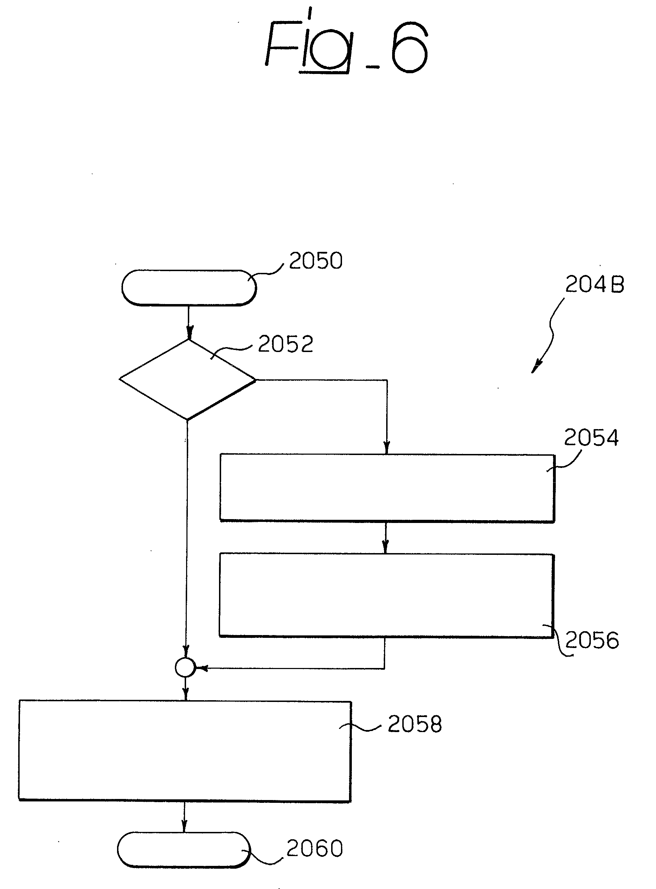

Periodic section 204 implements both control system and host interface functions according to the flowchart including the two subsequent portions designated 204A and 204B shown in figures 5 and 6.

Starting from a "start" step 2040, in a step designated 2042 the hardware interface functions are implemented. These include:

- reading the sensor signals (current values) corresponding to TEC and board temperatures, photodiode currents and TEC currents;
- updating driver signals (bias current, modulation current, TEC current and polarity), and
- reading/updating module signals, including reading TX_DISABLE signal and writing TX_FAULT signal.

Subsequent step designated 2044 corresponds to control functions proper namely:

- calculating the wavelength value,
- executing TEC temperature control,
- executing laser power control,
- executing wavelength control, and
- executing extinction ratio control.

The control functions in question are obviously carried out if enabled by the finite state machine.

Subsequent step 2046 corresponds to signal monitoring functions such as:

- verify if TEC temperature is stable,
- verify if laser power is stable,
- verify if laser wavelength is stable,
- setting any alarms corresponding to TEC temperature, laser power or laser wavelength falling outside of their respective valid ranges.

Step designated 2048 as a whole involves controlling operation of the finite state machine, namely performing the start-up procedure and/or passing through any states for:

- enabling/disabling any control function,
- enabling/disabling any alarm verification,
- turning on/off laser source 1,
- turning on/off the TEC,
- setting/resetting the TX_FAULT signal,
- setting new values for bias and modulation currents.

Step 2048 also involves verification of whether any alarm was triggered.

The subsequent step in periodic section 204 (step indicated 2050 in figures 5 and 6 being just a notional step intended to indicate that portion 204B follows section 204A) is a step designated 2052. This essentially involves a test aiming at ascertaining whether any new message was received on the 2-wire serial bus.

In the positive, a message validation step 2054 is performed to verify the message integrity and to verify whether the message contains a valid command.

Subsequent step 2056 corresponds to command execution, namely to verifying if the command is "factory only", whereby it can be executed only if the protection code is disabled, and otherwise executing any "customer" command.

Subsequent step 2058 (which is reached directly from step 2052 if this latter steps yields a negative outcome) corresponds to the ageing tracking function.

This involves calculating the time lapsed from the latest track-up action of ageing performed, and the new, updated values indicative of module ageing if the amount of time lapse is greater then a certain update threshold value (e.g. one day).

Finally, reference numeral 2060 indicates the final step of periodic section 204.

Of course, the principles of the invention remaining the same, the details of construction and the embodiments may widely vary with respect to what has been described and illustrated purely by way of example, without departing from the scope of the present invention as defined by the annexed claims. This applies to the possibility of adopting as the digital controller of the invention a type of controller different from and/or functionally equivalent to a micro-controller such as e. g. a microprocessor, a microcomputer or a digital controller constituted by a processing module/function of a digital processing device supervising operation of the module as a whole. Also, it will be appreciated that terms such as "optical", "light", "photosensitive", and the like are used herein with the meaning currently allotted to those terms in fiber and integrated optics, being thus intended to apply to radiation including in addition to visible light e.g. also infrared and ultraviolet radiation.

**Claims**

1.  A system for controlling the operating parameters of an optical source (1), the system including:

    -   a set of sensors (2, 3, 8) providing sensing signals indicative of said operating parameters to be controlled and
    -   a set of control elements (5 to 7) adapted to affect said operating parameters of said optical source in dependence of said sensing signals,

        **characterised in that** said set of control elements includes a digital controller (7) arranged to act both as a control system to maintain said operating parameters within respective pre-defined ranges and as a host interface to monitor said sensing signals and configure the system.

2.  The system of claim 1, **characterised in that** said set of sensors includes at least one analog sensor (2, 3, 8) and **in that** said controller (7) has associated at least one corresponding analog-to-digital converter (71, 72, 75) to convert the sensing signals generated by said at least one sensor (2, 3, 8) to the digital format.

3.  The system of either of claims 1 or 2, **characterised in that** said set of control elements includes at least one analog effector (5, 6) and **in that** said controller (7) has associated at least one digital-to-analog converter (75, 74) to convert to the analogue format the signals sent toward said at least one analog effector (5, 6).

4.  The system of any of the previous claims, **characterised in that** said set of sensors (2, 3, 8) includes at least one sensor sensitive to one operating parameter selected out of the group consisting of the power emitted (3), the radiation wavelength (2) and the ambience temperature (8) of said optical source (1).

5.  The system of any of the previous claims **characterised in that** said set of control elements (5 to 7) includes at least one control element adapted to control at least one of the bias current and the temperature of said optical source.

6.  The system of any of the previous claims, **characterising in that** it includes, as said optical source, a laser diode (1).

7.  The system of claim 1, **characterised in that** said controller (7) is arranged to perform at least one control function selected from the group consisting of:

    -   temperature control of said optical source (1) to maintain constant the temperature of said optical source,
    -   power control to maintain constant the optical power generated by said optical source (1),
    -   wavelength control to maintain constant the emission wavelength of said optical source (1), and
    -   extinction ratio control to maintain constant the ratio between the optical power generated by said optical source (1) as a result of generating "1" and "0" logical values when said optical source is subject to digital modulation.

8.  The system of claim 7, **characterised in that** said controller (7) includes a proportional-integral controller module in order to implement any of said temperature control, power control and wavelength control functions.

9. The system of either of claims 7 or 8 **characterised in that**:

   - said set of sensors (2, 3, 8) includes a first sensor (2) providing a first sensing signal ($Imf_x$) indicative of the wavelength of the radiation emitted by said optical source (1), said first sensing signal being also dependent on the power generated by said optical source (1),
   - a second sensing signal ($Imp_x$) indicative of the power generated by said optical source (1),

   and **in that** said controller (7) is arranged to perform said wavelength control function independently of any variations in the power generated by said optical source (1) as a function of a first (L) and a second target value ($D_{OFF}$), said target values being derived as a function of the values of said first sensing signal and said second sensing signals measured at a first and a second temperature.

10. The system of claim 9, **characterised in that** said controller (7) is arranged to define said first and second target values (L, $D_{OFF}$), on the basis of the following equation

$$L= (Imf_1.K+D_{OFF})/Imp_1$$

$$L= (Imf_2.K+D_{OFF})/Imp_2$$

   Where:

   - K is a constant value,
   - L and $D_{OFF}$ are said target values,
   - $Imf_1$ and $Imf_2$ are the values of said first sensing signal at said first and second temperatures, and
   - $Imp_1$ and $Imp_2$ are the values of said second sensing signal at said first and second temperatures.

11. The system of claim 8, **characterised in that** said controller (7) includes a feed forward module to implement said extinction ratio control function.

12. The system of claim 11, **characterised in that** said controller is sensitive to the bias current and the modulation current of said optical source (1), and **in that** a said controller (7) is arranged to perform an initial calibration step of said optical source (1) in order to set values for the modulation current and the bias current of said optical source (1) and calculating a proper coefficient for the modulation current as a linear function of the bias current in order to obtain the same extinction ratio at the same output power at least two and preferably three different temperatures, wherein said coefficient maintains said extinction ratio constant.

13. The system of any the previous claims **characterised in that** said controller (7) is configured to act as a host interface sensitive to a first class and a second class of commands, wherein said first class of commands are available only during a first programming phase to be disabled at the end of said programming phase.

14. The system of claim 13, wherein said first class of commands include commands allowing a factory host equipment to configure the system during said programming phase, whereby said first class of commands, once disabled, are no longer available a preventing the internal setting of the system from being inadvertently modified.

15. The system of either the claims 14 or 15 **characterising that** said second class of commands permit at least one of the following information to be read from outside the system:

   - optical source temperature,
   - optical source currents,
   - board temperature,
   - sensing signals generated by said set of sensors (2, 3, 8),
   - bias currents of said optical source,
   - modulation current of said optical source (1),
   - status of system,
   - system being in an alarm status,
   - a faulty condition having being detected in the system,
   - identification information of the system.

16. The system of any of claims 13 to 15, **characterised in that** said second class of commands also includes at least one of wavelength fine adjustment commands for said optical source (1),

   - actual operating point information of said optical source (1) for used as a target in future power-up.

17. The system of any of the previous claims, **characterised in that** said controller (7) is arranged to calculate an average value over a given time basis for at least one of said operating parameters, and **in that** the system further includes a memory (9) associated with said controller (7) to store said average value.

**18.** The system of either of claims 1 or 17 **characterised in that** said that controller (7) is arranged to perform, when the system is turned-on, a start-up procedure (202) involving setting said at least one of said operating parameters at a respective target value.

**19.** The system of claim 17 and claim 18 **characterising in that** said controller (7) uses, as said respective target value, the average value stored in said memory(9) .

**20.** The system of claim 19, **characterised in that** said controller (7) is arranged to update on a given time basis the value of said average value stored in said memory (9), whereby said average value is used during said start-up procedure as a target value compensated against ageing phenomena affecting said optical source (1).

**21.** The system of any of the previous claims, **characterised in that** said controller (7) is arranged to perform said control function on the basis of:

- a configuration section (202) executed when the system is turned on, and
- a periodic section (204) performed periodically during operation of the system.

**22.** The system of claim 21, **characterised in that** said configuration section (202) involves at least one of the following tasks:

- power up and interrupt initialisation (2024),
- input/output configuration and peripheral initialisation (2026),
- driver configuration and buffer initialisation (2028),
- control function initialisation by initialisation of respective variables (2030).

**23.** The system of either of claims 21 or 22, **characterised in that** said periodic section (204) involves at least one of the following tasks:

- hardware interface (2042), including reading said sensing signals provided by said set of sensors (2, 3, 8) and updating the drive signals of said set of control elements (5, 7),
- performing said control function (2044) by executing control of said operating parameters,
- monitoring (2046) the sensing signals generated by said set of sensors by checking stability thereof and/or violation of a respective valid range.

**24.** The system of claims 18 and 23, **characterising in that** said periodic section (204) includes performing said start-up procedure (2048).

**25.** The system of claim 21, **characterised in that** said periodic section (204) involves verifying (2048) if an alarm was triggered.

**26.** The system of claim 13 and claim 21, **characterised in that** said periodic section (204) involves verifying said command messages in order to ascertain whether they belong to either of said first class and second class of messages

**27.** The system of claim 19 and claim 21, **characterised in that** said periodic section (204) involves updating said at least one average signal stored in said memory (9).

**28.** The system of any of the previous claims, **characterised in that** said controller (7) includes a finite state machine (FSM).

**29.** The system of any of the previous claims, **characterised in that** said controller (7) includes a micro-controller.

**30.** A computer program product directly loadable into the internal memory (9) of a digital controller (7), comprising software code portions which cause a controller to perform the function of the controller of the system of any of claims 1 to 29 when said product is run on said controller (7).

Fig_1

Fig_2

TX_DISABLE=1

100

TX_DISABLE=0

101

102

103

104

105

106

107

TX_DISABLE=1
1083

1081          TX_FAULT=1          1082

108

_Fig _ 3_

```
              ┌─────────────┐
              │             │──── 200
              └─────────────┘
                     │
                     ▼
              ┌─────────────┐
              │             │──── 202
              └─────────────┘
                     │
                     ▼
        206          ○◄──────────────┐
         │           │               │
         ▼           ▼               │
   ┌──────────────┐     ┌──────────────┐
   │              │────►│              │──── 204
   └──────────────┘     └──────────────┘
```

_Fig _ 4_

```
              ┌─────────────┐
              │             │──── 2020
              └─────────────┘
                     │
                     ▼              2024        202
         ┌──────────────────────┐
         │                      │──┘
         │                      │
         └──────────────────────┘
                     │
                     ▼
         ┌──────────────────────┐
         │                      │
         │                      │──── 2026
         └──────────────────────┘
                     │
                     ▼
         ┌──────────────────────┐
         │                      │
         │                      │──── 2028
         └──────────────────────┘
                     │
                     ▼
         ┌──────────────────────┐
         │                      │
         │                      │──── 2030
         └──────────────────────┘
                     │
                     ▼
              ┌─────────────┐
              │             │──── 2022
              └─────────────┘
```

# Fig. 5

# Fig_6

European Patent Office

**EUROPEAN SEARCH REPORT**

Application Number

EP 02 25 1896

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 069 658 A (LUCENT TECHNOLOGIES INC) 17 January 2001 (2001-01-17) | 1-6 | H01S5/0687 H01S5/0683 |
| A | * column 4, line 15-38; figure 2 * * column 5, line 19-57 * * column 6, line 24-42; figures 3A,3B * | 7-30 | |
| A | EP 0 966 079 A (SANTEC CORP) 22 December 1999 (1999-12-22) * the whole document * | 1-9 | |
| A | EP 0 913 896 A (NIPPON ELECTRIC CO) 6 May 1999 (1999-05-06) * column 2, line 21-31 * | 1,9-11 | |
| A | US 5 216 682 A (HEDBERG MATS O J) 1 June 1993 (1993-06-01) * column 3, line 4-14 * | 1,9-11 | |
| A | EP 0 793 316 A (LUCENT TECHNOLOGIES INC) 3 September 1997 (1997-09-03) * column 5, line 1-10 * | 1 | TECHNICAL FIELDS SEARCHED (Int.Cl.7) |
| A | US 6 064 681 A (ACKERMAN DAVID ALAN) 16 May 2000 (2000-05-16) * the whole document * | 1 | H01S |
| A | EP 0 926 789 A (NORTHERN TELECOM LTD) 30 June 1999 (1999-06-30) * abstract; figure 2 * | 1-30 | |

The present search report has been drawn up for all claims

| Place of search | Date of completion of the search | Examiner |
|---|---|---|
| THE HAGUE | 21 February 2003 | Claessen, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

# EP 1 345 296 A1

**ANNEX TO THE EUROPEAN SEARCH REPORT
ON EUROPEAN PATENT APPLICATION NO.**

EP 02 25 1896

This annex lists the patent family members relating to the patent documents cited in the above-mentioned European search report.
The members are as contained in the European Patent Office EDP file on
The European Patent Office is in no way liable for these particulars which are merely given for the purpose of information.

21-02-2003

| Patent document cited in search report | | Publication date | Patent family member(s) | | Publication date |
|---|---|---|---|---|---|
| EP 1069658 | A | 17-01-2001 | US | 6516010 B1 | 04-02-2003 |
| | | | CN | 1280310 A | 17-01-2001 |
| | | | EP | 1069658 A1 | 17-01-2001 |
| | | | JP | 2001044558 A | 16-02-2001 |
| EP 0966079 | A | 22-12-1999 | JP | 2950813 B2 | 20-09-1999 |
| | | | JP | 2000012968 A | 14-01-2000 |
| | | | JP | 2950815 B2 | 20-09-1999 |
| | | | JP | 2000022259 A | 21-01-2000 |
| | | | EP | 0966079 A2 | 22-12-1999 |
| | | | US | 6122301 A | 19-09-2000 |
| EP 0913896 | A | 06-05-1999 | JP | 11135871 A | 21-05-1999 |
| | | | EP | 0913896 A2 | 06-05-1999 |
| | | | US | 6292497 B1 | 18-09-2001 |
| US 5216682 | A | 01-06-1993 | AU | 3577593 A | 03-09-1993 |
| | | | BR | 9305879 A | 19-08-1997 |
| | | | CA | 2125390 A1 | 19-08-1993 |
| | | | CN | 1076315 A ,B | 15-09-1993 |
| | | | DE | 69318134 D1 | 28-05-1998 |
| | | | DE | 69318134 T2 | 08-10-1998 |
| | | | DK | 626106 T3 | 01-02-1999 |
| | | | EP | 0626106 A1 | 30-11-1994 |
| | | | ES | 2118225 T3 | 16-09-1998 |
| | | | FI | 943717 A | 11-08-1994 |
| | | | JP | 3264669 B2 | 11-03-2002 |
| | | | JP | 7503812 T | 20-04-1995 |
| | | | MX | 9206950 A1 | 01-09-1993 |
| | | | NO | 942969 A | 11-08-1994 |
| | | | WO | 9316512 A1 | 19-08-1993 |
| EP 0793316 | A | 03-09-1997 | EP | 0793316 A1 | 03-09-1997 |
| | | | JP | 9321375 A | 12-12-1997 |
| | | | US | 5844928 A | 01-12-1998 |
| US 6064681 | A | 16-05-2000 | CA | 2310443 A1 | 11-12-2000 |
| | | | EP | 1059745 A2 | 13-12-2000 |
| | | | JP | 2001036190 A | 09-02-2001 |
| EP 0926789 | A | 30-06-1999 | US | 6101200 A | 08-08-2000 |
| | | | DE | 69805745 D1 | 11-07-2002 |
| | | | EP | 0926789 A2 | 30-06-1999 |
| | | | JP | 11238946 A | 31-08-1999 |

EPO FORM P0459

For more details about this annex : see Official Journal of the European Patent Office, No. 12/82